# EUROPEAN PATENT SPECIFICATION

(11) **EP 2 585 907 B1**
(45) Date of publication and mention of the grant of the patent: **16.05.2018**
(21) Application number: 11810085.8
(22) Date of filing: 27.06.2011
(51) Int. Cl.: G06F 9/30

(54) **ACCELERATING EXECUTION OF COMPRESSED CODE**
BESCHLEUNIGUNG DER AUSFÜHRUNG EINES KOMPRIMIERTEN CODES
ACCÉLÉRATION DE L'EXÉCUTION D'UN CODE COMPRESSÉ

(30) Priority: 27.06.2010 US 824187
(43) Date of publication of application: 01.05.2013
(73) Proprietor: Intel Corporation, Santa Clara, California 95052 (US)
(72) Inventor: BORIN, Edson, Santa Clara, CA 95054 (US); BRETERNITZ JR., Mauricio, Austin Texas 78759 (US); BONE, Nir, 18394 Afula Ha (IL); AVNI, Shlomo, 25210 Ein Hamifratz Ha (IL)
(74) Representative: Goddar, Heinz J.
(86) International application number: PCT/US2011/041967
(87) International publication number: WO 2012/012112

(56) References cited:
- EP-A2- 0 260 639
- US-A- 5 222 244
- US-A- 6 158 046
- US-A1- 2002 042 862
- US-A1- 2003 028 754
- US-A1- 2003 033 504
- US-A1- 2003 212 879
- US-A1- 2004 114 587
- US-A1- 2004 128 477
- US-A1- 2007 022 279
- US-A1- 2007 055 849
- LEKATSAS, A. ET AL.: 'A Unified Architecture for Adaptive Compression of Data and Code on Embedded Systems' 18TH INTERNATIONAL CONFERENCE ON VLSI DESI GN 03 January 2005, pages 117 - 123, XP010769842

## Description

### FIELD

The present disclosure generally relates to the field of computing. More particularly, an embodiment of the invention generally relates to accelerating execution of compressed code.

### BACKGROUND

Many applications are sensitive to code size footprint. One key example is mobile applications, which may use Read-Only Memory (ROM) based systems where the persistent memory storage is a key factor in overall system cost, size, or power consumption. In some instances, code compression may be used to mitigate at least some of these issues, sometimes with a performance decrease and/or power consumption increase due to the required on-the-fly decompression of the compressed code.

US 2007/022279 A1 discloses an arrangement for compressing microcode ROM using a clustering approach. The clustering approach groups similar columns of microcode into different clusters and identifies unique patterns within each cluster. Only unique patterns identified in each cluster are stored in a pattern storage. Furthermore, an index storage is used to store indices, which map an address of a microcode word to be fetched from the microcode ROM to unique patterns required for the microcode word.

The present invention is defined by an apparatus, a method and a computing system according to the independent claims. Preferred embodiments are defined in the dependent claims.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.
Figs. 1 and 2 illustrate embedded code compression before and after compressing, respectively.
Figs. 3, 5, and 7 illustrate block diagrams of pipelined decompressors, according to some embodiments.
Fig. 4 and 6 illustrate the data flowing into the pipelined decompressors, according to some embodiments.
Fig. 8 illustrates a flow diagram of a method according to an embodiment of the invention.
Figs. 9 and 10 illustrate block diagrams of embodiments of computing systems, which may be utilized to implement some embodiments discussed herein.
Fig. 11 illustrates a block diagram of a wireless local area or cellular network communication system in accordance with some embodiments.

### DETAILED DESCRIPTION

In the following description, numerous specific details are set forth in order to provide a thorough understanding of various embodiments. However, various embodiments of the invention may be practiced without the specific details. In other instances, well-known methods, procedures, components, and circuits have not been described in detail so as not to obscure the particular embodiments of the invention. Further, various aspects of embodiments of the invention may be performed using various means, such as integrated semiconductor circuits ("hardware"), computer-readable instructions organized into one or more programs ("software"), or some combination of hardware and software. For the purposes of this disclosure reference to "logic" shall mean either hardware, software (including for example micro-code that controls the operations of a processor), or some combination thereof.

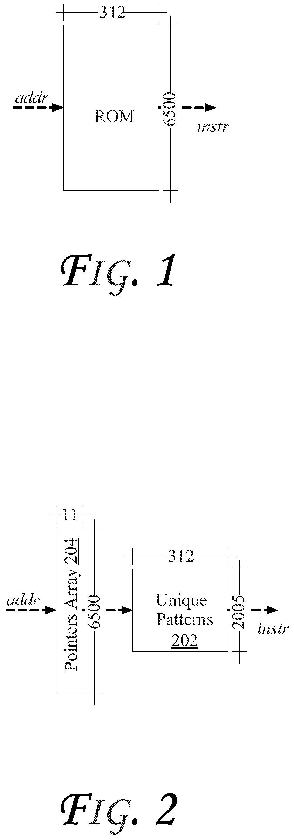

Some embodiments enhance a two-level embedded code decompression scheme, e.g., by reducing or eliminating the performance overhead for the most frequently executed code flows, reducing power consumption, and/or reducing code size. Generally, embedded code compression aims to identify a set of unique bit patterns that compose an embedded code word and to store them in a table (also referred to as a "dictionary"). The compressed embedded code stores a (short) *unique identifier* for each pattern in the original embedded code word sequence, as shown in Figs. 1 and 2. Moreover, an embodiment uses the flexibility in designating locations for values in the code dictionaries or memories to enable more efficient derivation of initial pointer values. Such embodiments may achieve the benefits provided by embedded code compression, while avoiding the extra costs in decompression performance.

In Figs. 1 and 2, *addr* refers to the address of an embedded code instruction. In the uncompressed form (see, e.g., Fig. 1), the *addr* directly accesses the ROM to fetch an embedded code instruction (*instr*)*.* In the compressed form (see, e.g., Fig. 2), the unique embedded code instructions are stored in the "unique patterns" table/array 202 (or dictionary), and only the index (pointer) to the pattern is stored in the original slot of the embedded code instructions (pointers array 204). This organization uses a 2-stage process to decompress an embedded code word: in the first stage the Pointers Array 204 is accessed to fetch an index (pointer) into the Unique Pattern array 202, which is in turn accessed to provide the word. Assume the original ROM has 6500 embedded code words each with 312 bits, and there are a total of 2005 unique embedded code words. The original ROM takes (312x6500) 2,028,000 bits and the compressed ROM takes only (6500*11 + 312*2005) 697,060 bits (where 11 is the number of bits required to index the 2005 entries in the unique pattern array 202). Hence, the compression ratio (compressed size /original size) is 34.37 %. Accordingly, previous approaches to embedded code decompression may incur a performance cost at flow changes. To this end, some embodiments avoid this performance hit while enabling compression.

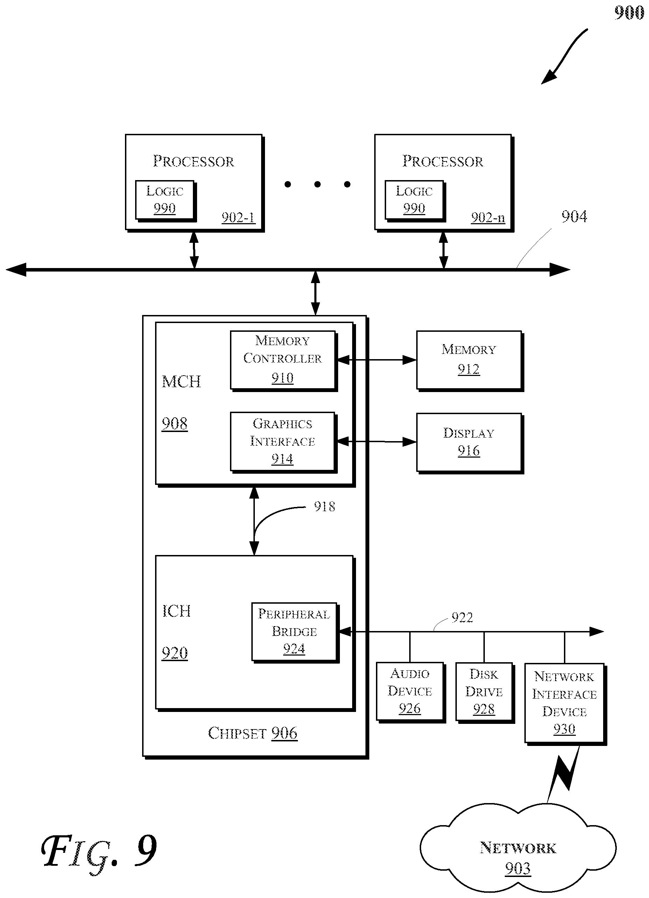

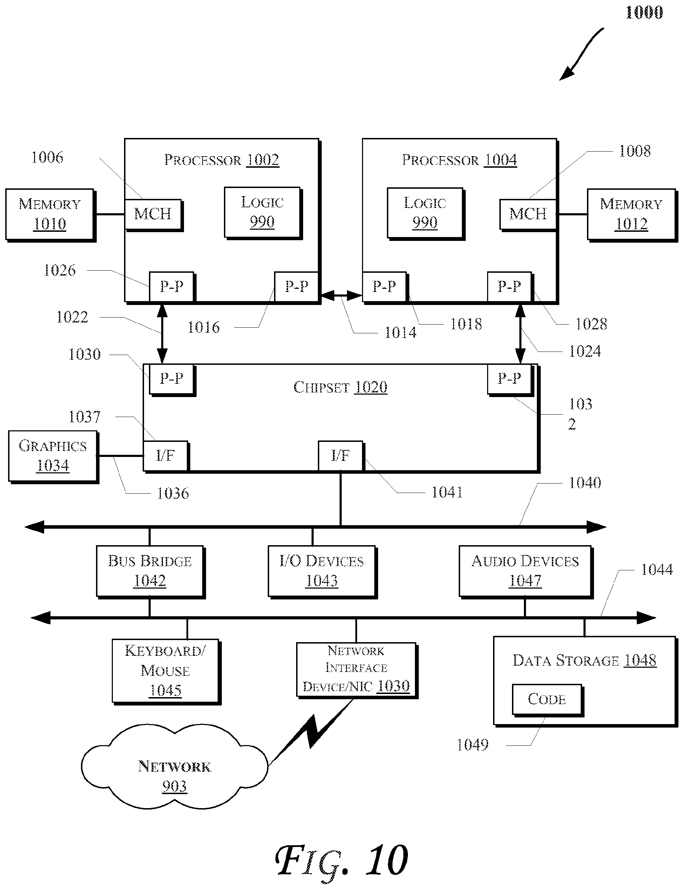

In various embodiments, the pointers arrays and unique pattern arrays/tables discussed herein may be implemented on separate storage units (such as memories discussed with reference to Figs. 9 or 10) or as regions within a same storage unit (such as memories discussed with reference to Figs. 9 or 10).

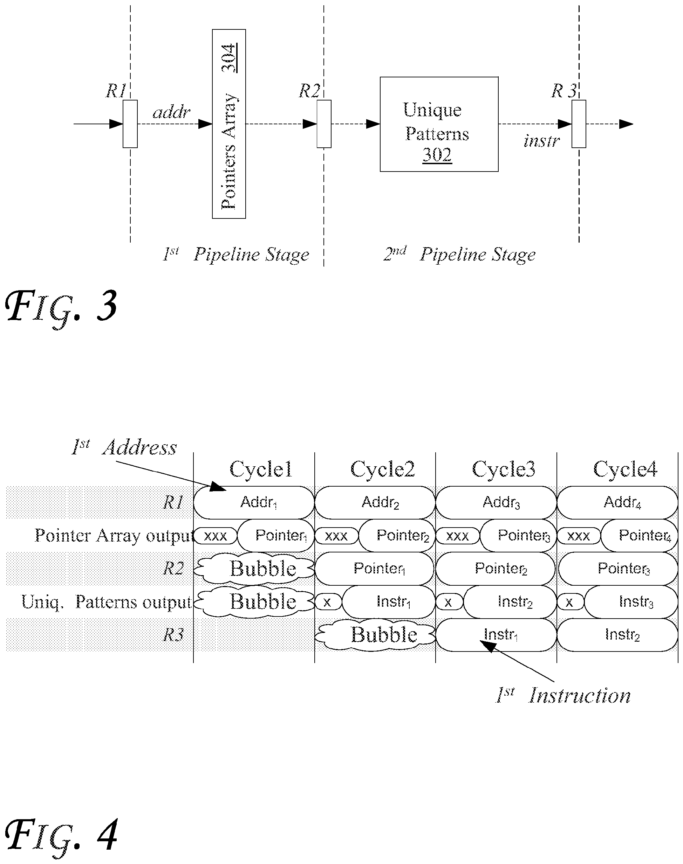

Fig. 3 illustrates a block diagram of a pipelined decompressor, according to an embodiment. In Figs. 3, 5, and 7, R1, R2, and R3 refer to registers or first-in, first-out (FIFO) buffers that may be used to temporary store data passing between pipeline stages. Fig. 4 illustrates data flowing into the pipelined decompressor of Fig. 3 in accordance with an embodiment.

Referring to Fig. 3, the compressed organization utilizes an indirect access to the "unique patterns" table 302. This indirection increases the time required to fetch an instruction from the memory that stores code. Notice that before fetching the instruction from the unique patterns array 302, the pointer is fetched from the pointers array 304. If the time period to fetch from both arrays 302 and 304 is not small enough to fit within the processor cycle time (i.e., is less than or equal to one cycle of the processor), it can affect the processor performance. In order to ensure that this time period fits within the processor cycle time, the compressed ROM may use only fixed-sized code instructions and/or be pipelined. Fig. 3 shows the decompressor pipelined with two stages. The first pipeline stage includes the pointers array 304 and the second pipeline stage includes the unique patterns table/array 302.

During execution, a sequence of 'addr' addresses is presented to the compressed ROM. In the pipeline decompressor of Fig. 3, the address is initially presented to the Pointers Array 304. In the next stage, this produces pointer(s) that access the Unique Pattern array 302, while simultaneously a new 'addr' is presented to the pointers array 304, with a throughput of one word per cycle. This pipelined organization incurs a one-cycle 'bubble' whenever a new sequence of 'addr' is started. A "bubble" happens when the pipeline is restarted. This happens, for example, at the beginning of an embedded code flow, or during jumps. Generally, a "bubble" is figurative representation that indicates that the pipeline stage (the one that contains the bubble) is not performing any useful work.

Referring to Fig. 4, the data flowing into the pipelined decompressor of Fig. 3 is shown. In the first cycle (Cycle 1), the input of the pointers array 304 contains the first instruction address (Addr1). In the second cycle (Cycle 2), the second instruction address (Addr2) is provided to the pointers array 304 while the first pointer (Pointer 1) is provided to the unique patterns array 302. The bubble at R2 happens because the decompressor cannot provide the pointer to the unique pattern array in the first cycle.

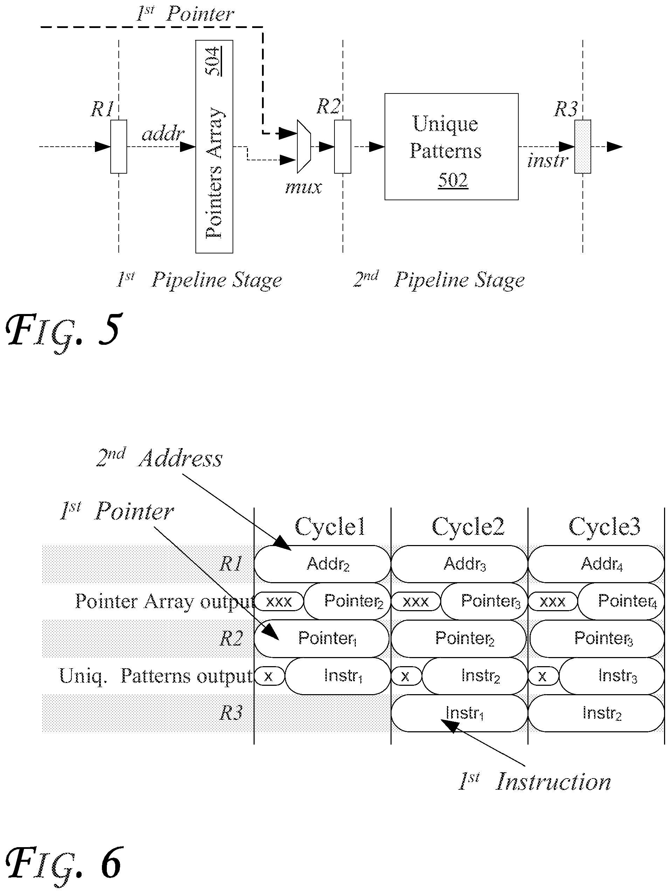

Fig. 5 illustrates a block diagram of a pipelined decompressor, according to an embodiment. The embodiment of Fig. 5 avoids the bubble at R1, discussed with reference to Figs. 3-4, by providing the first pointer (Pointer 1) directly (e.g., bypassing the pointers array 504) to the unique pattern array 502 at the same time the second address (Addr 2) is provided to the pointers array 504. As shown, a multiplexer may select the 1^{st} pointer or an output of the pointers array 504 for transmission to the second pipeline via R2. Thus, the first instruction is fetched directly from the Unique Pattern array 502 in the first cycle of a new flow, while the address of the second instruction ('addr') is used to 'prime' the pipeline.

Fig. 6 shows the data flowing into the pipelined decompressor of Fig. 5, e.g., when the 1^{st} pointer is provided directly to the unique patterns array. Notice that the bubble in the first cycle (Cycle 1) has been removed when compared with Fig. 4. In the first cycle, the input of the pointers array 504 contains the second instruction address and the input of the unique patterns array 502 includes the pointer to the 1^{st} instruction. In the second cycle (Cycle 2), the third instruction address is provided to the pointers array 504 while the second pointer is provided to the unique patterns array 502. In this example, the decompressor is able to provide the pointer to the unique pattern array in the first cycle, eliminating the bubble.

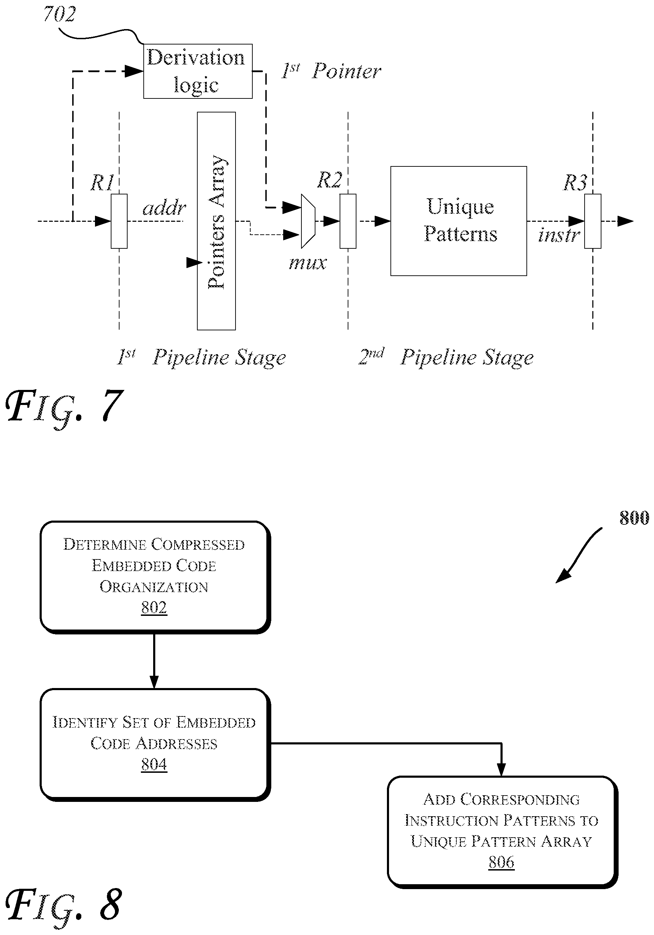

Fig. 7 illustrates a block diagram of a pipelined decompressor, according to an embodiment. The organization in Fig. 5 is augmented in Fig. 7 by avoiding bus wiring for extra address bits (and logic). The 1^{st} pointer is instead derived from the second instruction address ('addr') by a derivation logic 702. In an embodiment, the 'Derivation logic' may generate the 1^{st} Pointer by selecting a subset of the bits in 'addr', so the logic to derive may be implemented simply by wiring the select bits to the multiplexer in at least one embodiment.

In one embodiment, by rearranging the location of the patterns in the unique patterns array we modify the values stored in the pointers array (the value of the pointers). For illustration, assume that the instruction "ADD R, R" is the first instruction in the embedded code flow. We can store this instruction pattern in the unique patterns array in a position where the index is a subset of the second instruction address (Addr₂), so that the 1^{st} pointer can be easily derived from the 2^{nd} address. For example, if Addr₁ = 000100, and Addr₂ = 000101, the "ADD R, R" instruction could be stored in position 0101 in the unique patterns array, so that it's address could be directly derived from the low-order 4 bits of Addr₂. At the start of a flow, Addr₂ would be provided to R1, while its low-order 4 bits (0101) would be provided to R2, directly fetching the first instruction from the unique patterns array.

Also, such an embodiment may trade some compression (for enhanced performance), as it is conceivable that the "ADD R, R" instruction can be shared by another flow, requiring it to be duplicated in the unique patterns array to make its pointer data independent. However, this duplication only happens for (the relatively few) different instructions that are at the start of flows. Additionally, profiling could be used to select and optimize only the most frequently executed flows, leaving the bubble in the least frequently ones.

Fig. 8 illustrates a block diagram of a method 800 to enhance embedded codes, according to an embodiment. Operations of method 800 may be performed by one or more components discussed herein, e.g., with reference to Fig. 1-7 and/or 9-11.

Referring to Fig. 8, at an operation 802, a compressed embedded code organization is determined (as previously described), e.g., generating a Pointer array and a Unique Pattern array, indexed by P and U bits, respectively. At an operation 804, a set S of embedded code addresses (addr) are identified, which are the second instructions of (e.g., important) flows. Moreover, the embedded code may contain multiple flows. Each flow contains a sequence of instructions. Each one of these instructions is associated with an address, such as: addr1, addr2, addr3, ..., addrN. Addr2 is the address of the second instruction of a flow. Hence, operation 804 identifies the set of addresses that corresponds to the second instruction of each flow. Therefore, if the code has ten important flows or flows of interest, we will have a set with ten addresses, each one being the address of the second instruction in each flow. At an operation 806, for every element of S, the corresponding instruction patterns are added to the Unique Pattern array, for example, such that the pattern index can be easily derived from the second instruction address. In an embodiment, one could place the pattern in a position where the pattern index (composed of U bits) corresponds to a subset of the P bits of the second address (Addr2) in the flow.

Accordingly, in some embodiments, bubbles may be removed from an embedded compressed code flow to increase speed and/o reduce costs, by: (1) directly providing the pattern index for the first instruction in the flow to avoid the pipeline bubble; (2) deriving the pattern index from an instruction address; and/or (3) re-positioning patterns in the unique patterns array to simplify the logic to derive the pattern index from the instruction address.

In an embodiment, it is possible to trade compression ratio for performance by applying the techniques discussed herein (e.g., with reference to Figs. 1-8) selectively. For example, the techniques may be restricted to important, short embedded instruction flows, which are more sensitive to the initial pipeline 'bubble' delays. Also, relatively long, rare, flows that are less sensitive to one extra cycle may be performed without utilizing such techniques. Furthermore, at the embedded code link stage, embedded code may be reorganized to minimize the number of distinct unique instructions that are at the start of flows; thus, preserving the compression ratio.

Fig. 9 illustrates a block diagram of an embodiment of a computing system 900. In various embodiments, one or more of the components of the system 900 may be provided in various electronic devices capable of performing one or more of the operations discussed herein with reference to some embodiments of the invention. For example, one or more of the components of the system 900 may be used to perform the operations discussed with reference to Figs. 1-8 and 10-11. Also, various storage devices discussed herein (e.g., with reference to Figs. 9 and/or 10) may be used to store data (including instructions), operation results, etc. In one embodiment, data associated with operations of method 900 of Fig. 9 may be stored in memory device(s) (such as memory 912 or one or more caches (e.g., L1, mid-level, or last level caches in an embodiment) present in processors 902 of Fig. 9 or 1002/1004 of Fig. 10).

Moreover, the computing system 900 may include one or more central processing unit(s) (CPUs) 902 or processors that communicate via an interconnection network (or bus) 904. The processors 902 may include a general purpose processor, a network processor (that processes data communicated over a computer network 903), or other types of a processor (including a reduced instruction set computer (RISC) processor or a complex instruction set computer (CISC)). Moreover, the processors 902 may have a single or multiple core design. The processors 902 with a multiple core design may integrate different types of processor cores on the same integrated circuit (IC) die. Also, the processors 902 with a multiple core design may be implemented as symmetrical or asymmetrical multiprocessors. Additionally, the processors 902 may utilize an SIMD (Single Instruction, Multiple Data) architecture. Moreover, the operations discussed with reference to Figs. 1-8 may be performed by one or more components of the system 900. Also, as shown in Fig. 9, one or more of the processors 902 may include a (embedded) logic 990, which may be the same or similar to the decompressors discussed with reference to Figs. 1-8. Other embodiments of the invention, however, may exist in other circuits, logic units, or devices within the system 900 of Fig. 9.

A chipset 906 may also communicate with the interconnection network 904. The chipset 906 may include a memory control hub (MCH) 908. The MCH 908 may include a memory controller 910 that communicates with a memory 912. The memory 912 may store data, including sequences of instructions that are executed by the CPU 902, or any other device included in the computing system 900. In one embodiment of the invention, the memory 912 may include one or more volatile storage (or memory) devices such as random access memory (RAM), dynamic RAM (DRAM), synchronous DRAM (SDRAM), static RAM (SRAM), or other types of storage devices. Nonvolatile memory may also be utilized such as a hard disk. Additional devices may communicate via the interconnection network 904, such as multiple CPUs and/or multiple system memories.

The MCH 908 may also include a graphics interface 914 that communicates with a display 916. The display 916 may be used to show a user results of operations associated with the Brownian Bridge algorithm discussed herein. In one embodiment of the invention, the graphics interface 914 may communicate with the display 916. In an embodiment of the invention, the display 916 may be a flat panel display that communicates with the graphics interface 914 through, for example, a signal converter that translates a digital representation of an image stored in a storage device such as video memory or system memory into display signals that are interpreted and displayed by the display 916. The display signals produced by the interface 914 may pass through various control devices before being interpreted by and subsequently displayed on the display 916.

A hub interface 918 may allow the MCH 908 and an input/output control hub (ICH) 920 to communicate. The ICH 920 may provide an interface to I/O devices that communicate with the computing system 900. The ICH 920 may communicate with a bus 922 through a peripheral bridge (or controller) 924, such as a peripheral component interconnect (PCI) bridge, a universal serial bus (USB) controller, or other types of peripheral bridges or controllers. The bridge 924 may provide a data path between the CPU 902 and peripheral devices. Other types of topologies may be utilized. Also, multiple buses may communicate with the ICH 920, e.g., through multiple bridges or controllers. Moreover, other peripherals in communication with the ICH 920 may include, in various embodiments of the invention, integrated drive electronics (IDE) or small computer system interface (SCSI) hard drive(s), USB port(s), a keyboard, a mouse, parallel port(s), serial port(s), floppy disk drive(s), digital output support (e.g., digital video interface (DVI)), or other devices.

The bus 922 may communicate with an audio device 926, one or more disk drive(s) 928, and a network interface device 930, which may be in communication with the computer network 903. In an embodiment, the device 930 may be a NIC capable of wireless communication. Other devices may communicate via the bus 922. Also, various components (such as the network interface device 930) may communicate with the MCH 908 in some embodiments of the invention. In addition, the processor 902 and the MCH 908 may be combined to form a single chip. Furthermore, the graphics interface 914 may be included within the MCH 908 in other embodiments of the invention.

Furthermore, the computing system 900 may include volatile and/or nonvolatile memory (or storage). For example, nonvolatile memory may include one or more of the following: read-only memory (ROM), programmable ROM (PROM), erasable PROM (EPROM), electrically EPROM (EEPROM), a disk drive (e.g., 928), a floppy disk, a compact disk ROM (CD-ROM), a digital versatile disk (DVD), flash memory, a magnetooptical disk, or other types of nonvolatile machine-readable media that are capable of storing electronic data (e.g., including instructions). In an embodiment, components of the system 900 may be arranged in a point-to-point (PtP) configuration such as discussed with reference to Fig. 10. For example, processors, memory, and/or input/output devices may be interconnected by a number of point-to-point interfaces.

More specifically, Fig. 10 illustrates a computing system 1000 that is arranged in a point-to-point (PtP) configuration, according to an embodiment of the invention. In particular, Fig. 10 shows a system where processors, memory, and input/output devices are interconnected by a number of point-to-point interfaces. The operations discussed with reference to Figs. 1-9 and 11 may be performed by one or more components of the system 1000.

As illustrated in Fig. 10, the system 1000 may include several processors, of which only two, processors 1002 and 1004 are shown for clarity. The processors 1002 and 1004 may each include a local memory controller hub (MCH) 1006 and 1008 to couple with memories 1010 and 1012. The memories 1010 and/or 1012 may store various data such as those discussed with reference to the memory 912 of Fig. 9.

The processors 1002 and 1004 may be any suitable processor such as those discussed with reference to the processors 902 of Fig. 9. The processors 1002 and 1004 may exchange data via a point-to-point (PtP) interface 1014 using PtP interface circuits 1016 and 1018, respectively. The processors 1002 and 1004 may each exchange data with a chipset 1020 via individual PtP interfaces 1022 and 1024 using point to point interface circuits 1026, 1028, 1030, and 1032. The chipset 1020 may also exchange data with a high-performance graphics circuit 1034 via a high-performance graphics interface 1036, using a PtP interface circuit 1037.

At least one embodiment of the invention may be provided by utilizing the processors 1002 and 1004. For example, as shown in Fig. 10, one or more of the processors 1002/1004 may include a (embedded) logic 990, which may be the same or similar to the decompressors discussed with reference to Figs. 1-8. Other embodiments of the invention, however, may exist in other circuits, logic units, or devices within the system 1000 of Fig. 10. Furthermore, other embodiments of the invention may be distributed throughout several circuits, logic units, or devices illustrated in Fig. 10.

The chipset 1020 may be coupled to a bus 1040 using a PtP interface circuit 1041. The bus 1040 may have one or more devices coupled to it, such as a bus bridge 1042 and I/O devices 1043. Via a bus 1044, the bus bridge 1043 may be coupled to other devices such as a keyboard/mouse 1045, the network interface device 1030 discussed with reference to Fig. 10 (such as modems, network interface cards (NICs), or the like that may be coupled to the computer network 903), audio I/O device, and/or a data storage device 1048. The data storage device 1048 may store code 1049 that may be executed by the processors 1002 and/or 1004.

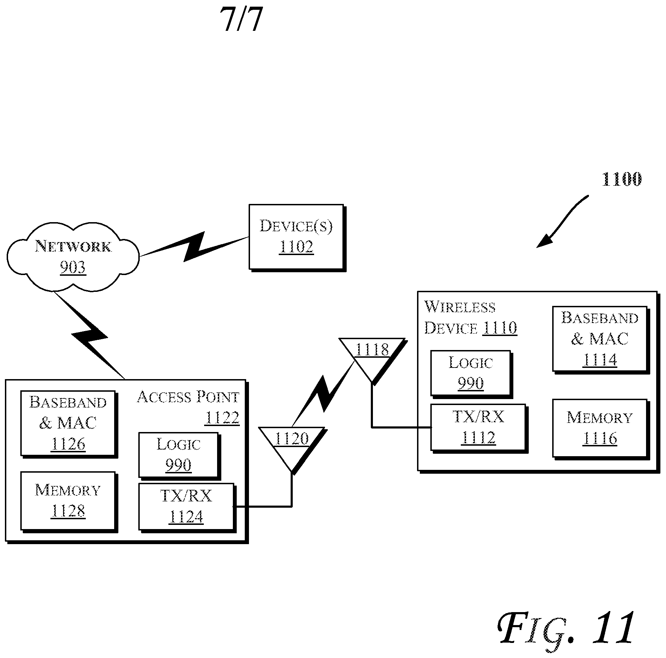

Referring to Fig. 11, a block diagram of a wireless local area or cellular network communication system 1100 in accordance with one or more embodiments will be discussed. In the communication system 1100 shown in Fig. 11, a wireless device 1110 may include a wireless transceiver 1112 to couple to an antenna 1118 and to a logic 1114 such as a processor (e.g., to provide baseband and media access control (MAC) processing functions). In some embodiment, one or more of the computing systems discussed herein may include one or more of the components discussed with reference to the wireless device 1110. Also, computing devices 1102 may include one or more components of systems/devices discussed herein with reference to Figs. 1-10.

In some embodiments, wireless device 1110 may be a cellular telephone or an information handling system such as a mobile personal computer or a personal digital assistant or the like that incorporates a cellular telephone communication module. Logic 1114 in one embodiment may comprise a single processor, or alternatively may comprise a baseband processor and an applications processor (e.g., where each processor discussed with reference to Fig. 11 may include one or more processor cores, or may be the same or similar to the processors discussed with reference to Figs. 1-10). Logic 1114 couples to a memory 1116 which may include volatile memory such as dynamic random-access memory (DRAM), non-volatile memory such as flash memory, or alternatively may include other types of storage such as a hard disk drive. Some portion or all of memory 1116 may be included on the same integrated circuit as logic 1114, or alternatively some portion or all of memory 1116 may be disposed on an integrated circuit or other medium, for example a hard disk drive, that is external to the integrated circuit of logic 1114.

Wireless device 1110 may communicate with access point 1122 via a wireless communication link, where access point 1122 may include one or more of: an antenna 1120, a transceiver 1124, a processor 1126, and a memory 1128. As shown in Fig. 11, one or more of the wireless device 1110 and/or the access point 1122 may include a (embedded) logic 990, which may be the same or similar to the decompressors discussed with reference to Figs. 1-10. In one embodiment, access point 1122 may be a base station of a cellular telephone network, and in another embodiment, access point 1122 may be a an access point or wireless router of a wireless local or personal area network. In an embodiment, access point 1122 (and optionally wireless device 1110) may include two or more antennas, for example to provide a spatial division multiple access (SDMA) system or a multiple input, multiple output (MIMO) system. Access point 1122 may couple with network 903, so that wireless device 1110 may communicate with network 903, including devices coupled to network 903, by communicating with access point 1122 via a wireless communication link. Network 903 may include a public network such as a telephone network or the Internet, or alternatively network 903 may include a private network such as an intranet, or a combination of a public and a private network. Communication between wireless device 1110 and access point 1122 may be implemented via a wireless local area network (WLAN). In one embodiment, communication between wireless device 1110 and access point 1122 may be at least partially implemented via a cellular communication network compliant with a Third Generation Partnership Project (3GPP or 3G) standard. In some embodiments, antenna 1118 may be utilized in a wireless sensor network or a mesh network.

In various embodiments of the invention, the operations discussed herein, e.g., with reference to Figs. 1-11, may be implemented as hardware (e.g., logic circuitry), software (including, for example, micro-code that controls the operations of a processor such as the processors discussed herein, firmware, or combinations thereof, which may be provided as a computer program product, e.g., including a tangible machine-readable or computer-readable medium having stored thereon instructions (or software procedures) used to program a computer (e.g., a processor or other logic of a computing device) to perform an operation discussed herein. The machine-readable medium may include a storage device discussed herein.

Additionally, such tangible computer-readable media may be downloaded as a computer program product, wherein the program may be transferred from a remote computer (e.g., a server) to a requesting computer (e.g., a client) by way of data signals in propagation medium via a communication link (e.g., a bus, a modem, or a network connection).

Reference in the specification to "one embodiment" or "an embodiment" means that a particular feature, structure, or characteristic described in connection with the embodiment may be included in at least an implementation. The appearances of the phrase "in one embodiment" in various places in the specification may or may not be all referring to the same embodiment.

Also, in the description and claims, the terms "coupled" and "connected," along with their derivatives, may be used. In some embodiments of the invention, "connected" may be used to indicate that two or more elements are in direct physical or electrical contact with each other. "Coupled" may mean that two or more elements are in direct physical or electrical contact. However, "coupled" may also mean that two or more elements may not be in direct contact with each other, but may still cooperate or interact with each other.

Thus, although embodiments of the invention have been described in language specific to structural features and/or methodological acts, it is to be understood that claimed subject matter may not be limited to the specific features or acts described. Rather, the specific features and acts are disclosed as sample forms of implementing the claimed subject matter.

## Claims

1. An apparatus comprising:
a pipelined decompressor comprising:
in a first pipeline stage, a first storage unit (504) to store a pointer corresponding to a compressed code instruction address, and
in a second pipeline stage, a second storage unit (502) to store a unique instruction corresponding to the pointer; and
a processor to execute the stored instruction, wherein the first storage unit (504) is accessed in a first cycle to transmit the pointer to the second storage unit (502) in response to a receipt of the compressed code instruction address at the first storage unit (504), and
wherein the second storage unit (502) is accessed in a second cycle to output the unique instruction in response to a receipt of the pointer at the second storage unit (502),
**characterized in that**
during a first cycle of a new sequence of compressed code instruction addresses, wherein the decompressor pipeline is re-started, the second storage unit (502) receives a first pointer, corresponding to a first compressed code instruction address of the new sequence, from a derivation logic (702), wherein the first pointer is derived from a value of a second compressed code instruction address of the new sequence, wherein the first pointer is provided directly to the second storage unit (502), bypassing the first storage unit (504); and
the first storage unit (504) receives the second compressed code instruction address during the first cycle,

2. The apparatus of claim 1, wherein, during each subsequent cycle of the processor, after a first cycle of new sequences of compressed code instruction addresses, at least one pointer is to be fetched from the first storage unit (504) and at least one unique instruction is to be fetched from the second storage unit (502).

3. The apparatus of claim 1, wherein a time period to fetch the pointer from the first storage unit (504) and fetch the unique instruction from the second storage unit (502) is equal to or less than one cycle of the processor.

4. The apparatus of claim 1, wherein the unique instruction is to comprise a set of unique bit pattern, stored in the second storage unit (502), which compose an embedded code word.

5. The apparatus of claim 1, further comprising a read-only memory, wherein the memory is to comprise the first storage unit (504) or the second storage unit (502).

6. The apparatus of claim 1, further comprising at least one buffer or register (R2) to couple the first storage unit (504) and the second storage unit (502).

7. The apparatus of claim 1, further comprising a multiplexer to couple the first storage unit (504) and the second storage unit (502).

8. The apparatus of claim 1, wherein one or more of the processor, the first storage unit (504) , or the second storage unit (502) are on a same integrated circuit die.

9. The apparatus of claim 1, wherein the processor comprises a plurality of processor cores.

10. A method comprising:
storing a pointer corresponding to a compressed code instruction address in a first storage unit in a first pipeline stage of a pipelined decompressor;
storing a unique instruction corresponding to the pointer in a second storage unit in a second pipeline stage of the pipelined decompressor;
wherein, in a first cycle, the first storage unit is to transmit the pointer to the second storage unit in response to a receipt of the compressed code instruction address at the first storage unit,
wherein, in a second cycle, the second storage unit is to output the unique instruction in response to a receipt of the pointer at the second storage unit;
**characterized by**:
during a first cycle of a new sequence of compressed code instruction addresses, wherein the decompressor pipeline is re-started, receiving, from a derivation logic, at the second storage unit a first pointer, corresponding to a first compressed code instruction address of the new sequence, wherein the first pointer is derived from a value of a second compressed code instruction address of the new sequence, wherein the first pointer is provided directly to the second storage unit, bypassing the first storage unit;
receiving the second compressed code instruction address at the first storage unit during the first cycle; and
executing the stored instruction by a processor.

11. The method of claim 10, further comprising fetching, during each subsequent cycle of the processor, after a first cycle of new sequences of compressed code instruction addresses, at least one pointer from the first storage unit and at least one unique instruction from the second storage unit.

12. A computer-readable medium comprising one or more instructions that when executed on an apparatus with a processor and a pipelined decompressor having a first storage unit in a first pipeline stage and a second storage unit in a second pipeline stage, configure the apparatus to perform a method according to claim 10 or 11.

## Patentansprüche

1. Vorrichtung, aufweisend:
einen pipelineartigen Dekomprimierer, aufweisend:
in einer ersten Pipelinestufe, eine erste Speichereinheit (504) zum Speichern eines Zeigers, der einer Adresse einer komprimierten Code-Anweisungs-Adresse entspricht, und
in einer zweiten Pipelinestufe, eine zweite Speichereinheit (502) zum Speichern einer eindeutigen Anweisung, die dem Zeiger entspricht; und
einen Prozessor zum Ausführen der gespeicherten Anweisung, wobei in einem ersten Zyklus auf die erste Speichereinheit (504) zugegriffen wird, um als Reaktion auf einen Empfang der komprimierten Code-Anweisungs-Adresse in der ersten Speichereinheit (504) den Zeiger an die zweite Speichereinheit (502) zu senden, und
wobei in einem zweiten Zyklus auf die zweite Speichereinheit (502) zugegriffen wird, um die eindeutige Anweisung als Reaktion auf einen Empfang des Zeigers in der zweiten Speichereinheit (502) auszugeben,
**dadurch gekennzeichnet, dass**
während eines ersten Zyklus einer neuen Sequenz von komprimierten Code-Anweisungs-Adressen, wobei die Dekomprimierer-Pipeline neu gestartet wird, die zweite Speichereinheit (502) einen ersten Zeiger, der einer ersten komprimierten Code-Anweisungs-Adresse der neuen Sequenz entspricht, von einer Ableitungslogik (702) empfängt, wobei der erste Zeiger von einem Wert einer zweiten komprimierten Code-Anweisungs-Adresse der neuen Sequenz abgeleitet ist, wobei der erste Zeiger unter Umgehung der ersten Speichereinheit (504) direkt an die zweite Speichereinheit (502) bereitgestellt wird; und
während des ersten Zyklus die erste Speichereinheit (504) die zweite komprimierte Code-Anweisungs-Adresse empfängt.

2. Vorrichtung nach Anspruch 1, wobei, während jedes nachfolgenden Zyklus des Prozessors, nach einem ersten Zyklus neuer Sequenzen von komprimierten Code-Anweisungs-Adressen, mindestens ein Zeiger aus der ersten Speichereinheit (504) abgerufen werden soll und mindestens eine eindeutige Anweisung aus der zweiten Speichereinheit (502) abgerufen werden soll.

3. Vorrichtung nach Anspruch 1, wobei eine Zeitspanne zum Abrufen des Zeigers aus der ersten Speichereinheit (504) und zum Abrufen der eindeutigen Anweisung aus der zweiten Speichereinheit (502) gleich oder kleiner als ein Zyklus des Prozessors ist.

4. Vorrichtung nach Anspruch 1, wobei die eindeutige Anweisung einen Satz eines in der zweiten Speichereinheit (502) gespeicherten eindeutigen Bitmusters, das ein eingebettetes Codewort bildet, aufzuweisen hat.

5. Vorrichtung nach Anspruch 1, ferner aufweisend einen Nur-Lese-Speicher, wobei der Speicher die erste Speichereinheit (504) oder die zweite Speichereinheit (502) aufzuweisen hat.

6. Vorrichtung nach Anspruch 1, ferner aufweisend mindestens einen Puffer oder ein Register (R2), um die erste Speichereinheit (504) und die zweite Speichereinheit (502) zu verbinden.

7. Vorrichtung nach Anspruch 1, ferner aufweisend einen Multiplexer, um die erste Speichereinheit (504) und die zweite Speichereinheit (502) zu verbinden.

8. Vorrichtung nach Anspruch 1, wobei einer oder mehrere von dem Prozessor, der ersten Speichereinheit (504) oder der zweiten Speichereinheit (502) sich auf demselben Chip einer integrierten Schaltung befinden.

9. Vorrichtung nach Anspruch 1, wobei der Prozessor mehrere Prozessorkerne aufweist.

10. Verfahren, aufweisend:
Speichern eines Zeigers, der einer komprimierten Code-Anweisungs-Adresse entspricht, in einer ersten Speichereinheit in einer ersten Pipelinestufe eines pipelineartigen Dekomprimierers;
Speichern einer eindeutigen Anweisung, die dem Zeiger entspricht, in einer zweiten Speichereinheit in einer zweiten Pipelinestufe des pipelineartigen Dekomprimierers;
wobei in einem ersten Zyklus die erste Speichereinheit den Zeiger als Antwort auf einen Empfang der komprimierten Code-Anweisungs-Adresse in der ersten Speichereinheit an die zweite Speichereinheit zu senden hat,
wobei in einem zweiten Zyklus die zweite Speichereinheit die eindeutige Anweisung als Antwort auf einen Empfang des Zeigers in der zweiten Speichereinheit auszugeben hat;
**gekennzeichnet durch**:
während eines ersten Zyklus einer neuen Sequenz von komprimierten Code-Anweisungs-Adressen, wobei die Dekomprimierer-Pipeline neu gestartet wird, Empfangen, von einer Ableitungslogik, in der zweiten Speichereinheit, eines ersten Zeigers, der einer ersten komprimierten Code-Anweisungs-Adresse der neuen Sequenz entspricht, wobei der erste Zeiger von einem Wert einer zweiten komprimierten Code-Anweisungs-Adresse der neuen Sequenz abgeleitet wird, wobei der erste Zeiger unter Umgehung der ersten Speichereinheit direkt an die zweite Speichereinheit bereitgestellt wird;
Empfangen der zweiten komprimierten Code-Anweisungs-Adresse in der ersten Speichereinheit während des ersten Zyklus; und
Ausführen der gespeicherten Anweisung durch einen Prozessor.

11. Verfahren nach Anspruch 10, ferner aufweisend Abrufen, während jedes nachfolgenden Zyklus des Prozessors, nach einem ersten Zyklus neuer Sequenzen komprimierter Code-Anweisungs-Adressen, mindestens eines Zeigers aus der ersten Speichereinheit und mindestens einer eindeutigen Anweisung aus der zweiten Speichereinheit.

12. Computerlesbares Medium mit einer oder mehreren Anweisungen, die, wenn sie auf einer Vorrichtung mit einem Prozessor und einem Pipeline-Dekomprimierer mit einer ersten Speichereinheit in einer ersten Pipelinestufe und einer zweiten Speichereinheit in einer zweiten Pipelinestufe ausgeführt werden, die Vorrichtung konfigurieren, ein Verfahren nach Anspruch 10 oder 11 durchzuführen.

## Revendications

1. Appareil comprenant :
un dispositif de décompression en pipeline comprenant :
dans un premier étage de pipeline, une première unité de stockage (504) pour stocker un pointeur correspondant à une adresse d'instruction de code compressé et
dans un second étage de pipeline, une seconde unité de stockage (502) pour stocker une unique instruction correspondant au pointeur ; et
un processeur pour exécuter l'instruction stockée, dans lequel il existe un accès à la première unité de stockage (504) dans un premier cycle pour transmettre le pointeur à la seconde unité de stockage (502) à la suite d'une réception de l'adresse d'instruction de code compressé au niveau de la première unité de stockage (504) et
dans lequel il existe un accès à la seconde unité de stockage (502) dans un second cycle pour sortir l'unique instruction à la suite d'une réception du pointeur au niveau de la seconde unité de stockage (502),
**caractérisé en ce que**
pendant un premier cycle d'une nouvelle séquence d'adresses d'instruction de code compressé, dans lequel le pipeline de dispositif de décompression est remis en marche, la seconde unité de stockage (502) reçoit un premier pointeur, correspondant à une première adresse d'instruction de code compressé de la nouvelle séquence, en provenance d'une logique de dérivation (702), dans lequel le premier pointeur est dérivé d'une valeur d'une seconde adresse d'instruction de code compressé de la nouvelle séquence, dans lequel le premier pointeur est fourni directement à la seconde unité de stockage (502), évitant la première unité de stockage (504) ; et
la première unité de stockage (504) reçoit la seconde adresse d'instruction de code compressé pendant le premier cycle.

2. Appareil selon la revendication 1, dans lequel, pendant chaque cycle ultérieur du processeur, après un premier cycle de nouvelles séquences d'adresses d'instruction de code compressé, au moins un pointeur doit être extrait de la première unité de stockage (504) et au moins une unique instruction doit être extraite de la seconde unité de stockage (502).

3. Appareil selon la revendication 1, dans lequel une période de temps pour extraire le pointeur de la première unité de stockage (504) et extraire l'unique instruction de la seconde unité de stockage (502) est égale ou inférieure à un cycle du processeur.

4. Appareil selon la revendication 1, dans lequel l'unique instruction doit comprendre un ensemble de profils binaires uniques, stockés dans la seconde unité de stockage (502), qui comprennent un mot de code incorporé.

5. Appareil selon la revendication 1, comprenant en outre une mémoire morte, dans lequel la mémoire doit comprendre la première unité de stockage (504) ou la seconde unité de stockage (502).

6. Appareil selon la revendication 1, comprenant en outre au moins une mémoire tampon ou un registre (R2) pour coupler la première unité de stockage (504) et la seconde unité de stockage (502).

7. Appareil selon la revendication 1, comprenant en outre un multiplexeur pour coupler la première unité de stockage (504) et la seconde unité de stockage (502).

8. Appareil selon la revendication 1, dans lequel le processeur et/ou la première unité de stockage (504) et/ou la seconde unité de stockage (502) sont sur une même puce de circuit intégré.

9. Appareil selon la revendication 1, dans lequel le processeur comprend une pluralité de coeurs de processeur.

10. Procédé consistant :
à stocker un pointeur correspondant à une adresse d'instruction de code compressé dans une première unité de stockage dans un premier étage de pipeline d'un dispositif de décompression en pipeline ;
à stocker une unique instruction correspondant au pointeur dans une seconde unité de stockage dans un second étage de pipeline du dispositif de décompression en pipeline ;
dans lequel, dans un premier cycle, la première unité de stockage doit transmettre le pointeur à la seconde unité de stockage à la suite d'une réception de l'adresse d'instruction de code compressé au niveau de la première unité de stockage,
dans lequel, dans un second cycle, la seconde unité de stockage doit sortir l'unique instruction à la suite d'une réception du pointeur au niveau de la seconde unité de stockage ;
**caractérisé par** :
pendant un premier cycle d'une nouvelle séquence d'adresses d'instruction de code compressé, dans lequel le pipeline de dispositif de décompression est remis en marche, la réception, d'une logique de dérivation, au niveau de la seconde unité de stockage, d'un premier pointeur, correspondant à une première adresse d'instruction de code compressé de la nouvelle séquence, dans lequel le premier pointeur est dérivé d'une valeur d'une seconde adresse d'instruction de code compressé de la nouvelle séquence, dans lequel le premier pointeur est fourni directement à la seconde unité de stockage, évitant la première unité de stockage ;
la réception de la seconde adresse d'instruction de code compressé au niveau de la première unité de stockage pendant le premier cycle ; et
l'exécution de l'instruction stockée au moyen d'un processeur.

11. Procédé selon la revendication 10, consistant en outre à extraire, pendant chaque cycle ultérieur du processeur, après un premier cycle de nouvelles séquences d'adresses d'instruction de code compressé, au moins un pointeur de la première unité de stockage et au moins une unique instruction de la seconde unité de stockage.

12. Support lisible par ordinateur, comprenant une ou plusieurs instructions qui, lorsqu'elles sont exécutées sur un appareil doté d'un processeur et d'un dispositif de décompression en pipeline ayant une première unité de stockage dans un premier étage de pipeline et une seconde unité de stockage dans un second étage de pipeline, configurent l'appareil pour réaliser un procédé selon la revendication 10 ou 11.
